# EUROPEAN PATENT APPLICATION

(11) **EP 4 557 352 A1**
(43) Date of publication of application: **21.05.2025**
(21) Application number: 23926302.3
(22) Date of filing: 08.03.2023
(51) Int. Cl.: H01L 21/368, H01L 21/208

(54) **COATING APPARATUS AND COATING METHOD**

(71) Applicant: Kabushiki Kaisha Toshiba, Tokyo 105-0023 (JP); Toshiba Energy Systems & Solutions Corporation, Saiwai-ku Kawasaki-shi Kanagawa 2120013 (JP)
(72) Inventor: SHIDA, Naomi, Tokyo 105-0023 (JP); NAITO, Katsuyuki, Kawasaki-shi, Kanagawa 210-0024 (JP); HIRAOKA, Toshiro, Tokyo 105-0023 (JP); TOBARI, Tomohiro, Kawasaki-shi, Kanagawa 212-0013 (JP); ASATANI, Tsuyoshi, Kawasaki-shi, Kanagawa 212-0013 (JP)
(74) Representative: Marks & Clerk LLP
(86) International application number: PCT/JP2023/008884
(87) International publication number: WO 2024/185092

(57) **Abstract**

According to an embodiment, a coating device and a coating method capable of forming a uniform coating film are provided. A coating device 100 includes a coating bar, a base material conveyance member that conveys a base material, and a coating liquid supply member that supplies a coating liquid to the coating bar. Further, the coating device 100 further includes a leveling bar provided at a position downstream of the coating bar in a coating direction, and the leveling bar is arranged at a position where the coating liquid forms a meniscus between the leveling bar and the base material.

## Description

### TECHNICAL FIELD

Embodiments of the present invention relate to a coating device and a coating method that can be used for device formation.

### BACKGROUND ART

Organic thin-film solar cells using an organic semiconductor and organic/inorganic hybrid solar cells are expected as low-cost solar cells because an inexpensive coating method can be applied to form an active layer. In order to implement the organic thin-film solar cell and the organic/inorganic hybrid solar cell at low cost, it is required to uniformly apply a coating material for forming an organic active layer and other layers. The thickness of each layer is about several nm to several 100 nm, and it is required to form such a very thin layer with a large area and high uniformity. For example, a meniscus coating method or a slit coating method is known as a roll-to-roll (R2R) coating method capable of forming an extremely thin layer over a large area at low cost. However, it may be difficult to obtain a uniform thickness only by adopting these known methods according to related arts as they are, and a coating device capable of forming a uniform coating film by applying a liquid using a uniform coating bar is desired.

### CITATION LIST

### PATENT LITERATURE

Patent Literature 1: JP 2003-251256 A

### SUMMARY OF THE INVENTION

### OBJECT OF THE INVENTION

Embodiments of the present invention provide a coating device and a coating method capable of forming a uniform coating film.

### SOLUTION TO PROBLEM

Embodiments provided by the present invention are as follows:
[1] A coating device including: a coating bar; a base material conveyance member that conveys a base material; and a coating liquid supply member that supplies a coating liquid to said coating bar, in which said coating device further includes a leveling bar provided at a position downstream of said coating bar in a coating direction, and said leveling bar is arranged at a position where said coating liquid forms a meniscus between said leveling bar and said base material.
[2] The coating device according to [1], further including a leveling bar position adjustment member that controls an interval between said leveling bar and said base material.
[3] The coating device according to [1] or [2], in which said leveling bar is arranged so as not to rotate.
[4] The coating device according to any one of [1] to [3], further including a coating bar position adjustment member that controls a position of said coating bar.
[5] The coating device according to any one of [1] to [4], in which said coating liquid is supplied from a plurality of nozzles.
[6] The coating device according to [5], in which opening surfaces of the plurality of nozzles have a needle shape cut to an angle of 75 degrees or more and 105 degrees or less.
[7] The coating device according to [5] or [6], in which said nozzle is detachable.
[8] The coating device according to any one of [5] to [7], further including a nozzle that supplies said coating liquid to said leveling bar.
[9] The coating device according to any one of [1] to [4], in which said coating liquid is supplied from a slit die head.
[10] The coating device according to any one of [1] to [9], in which said leveling bar is curved.
[11] A coating method for preparing a coating film by applying a coating liquid to a surface of a base material using a coating bar, said coating method including: arranging a leveling bar at a position downstream of said coating bar in a coating direction; and forming a meniscus between said base material and said leveling bar by said coating liquid supplied from a primary coating film formed by said coating bar to form a secondary coating film.
[12] The coating method according to [11], in which said coating liquid is supplied from a plurality of nozzles to a surface of said coating bar, and said coating liquid is supplied from said surface to between said coating bar and said base material to form the primary coating film.
[13] The coating method according to [12], in which said coating liquid is supplied after adjusting positions of the plurality of nozzles and detecting a distance between said coating bar and the plurality of nozzles.
[14] The coating method according to [13], in which said distance is detected by measuring an electric resistance between said nozzle and said coating bar.
[15] The coating method according to any one of [12] to [14], in which the plurality of nozzles are installed on one cantilever fixing plate capable of rotation, horizontal movement, or vertical movement.

### BRIEF DESCRIPTION OF DRAWINGS

[Fig. 1] Fig. 1 is a schematic side view illustrating a coating device according to a first embodiment.
[Fig. 2] Fig. 2 is a schematic top view illustrating the coating device according to the first embodiment.
[Fig. 3] Fig. 3 is a flowchart illustrating a coating method according to a second embodiment.

### BEST MODE FOR CARRYING OUT THE INVENTION

Hereinafter, embodiments of the present invention will be described in detail with reference to the drawings.

Note that the drawings are schematic or conceptual, and a relationship between a thickness and a width of each portion, a ratio between sizes of portions, and the like are not necessarily the same as actual ones. In addition, even in a case of representing the same portion, dimensions and ratios may be illustrated differently from each other depending on the drawings.

Note that, in the present specification and the respective drawings, elements similar to those described above in the previously described drawings are denoted by the same reference numerals, and the detailed description thereof is appropriately omitted.

### (First Embodiment)

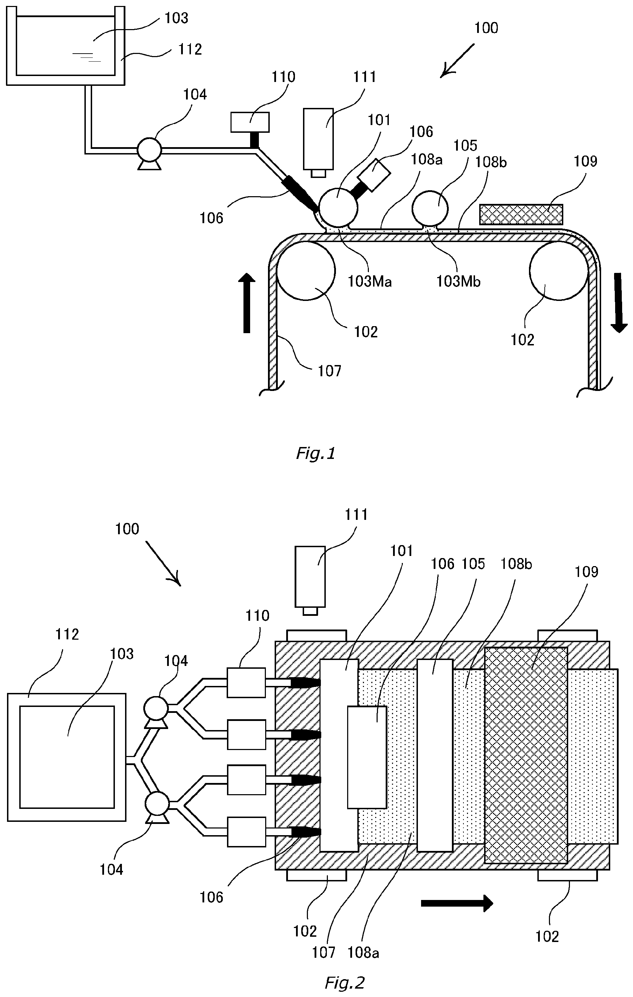

Fig. 1 is a schematic side view illustrating a coating device according to a first embodiment. Fig. 2 is a schematic top view illustrating the coating device according to the first embodiment.

As illustrated in Fig. 1, a coating device 100 according to the embodiment includes a coating bar 101, a base material conveyance member 102 that conveys a base material, a coating liquid supply member 104 that supplies a coating liquid 103 stored in a liquid reservoir 112 to the coating bar, and a leveling bar 105. The leveling bar 105 is arranged at a position where the coating liquid forms a meniscus between the leveling bar and the base material. Then, in this example, a primary coating film is formed by a so-called meniscus method using the coating bar. Each member is arranged such that the coating liquid 103 is supplied from a nozzle 106 to a surface of the coating bar 101, the coating liquid flows from the surface of the coating bar to between the coating bar 101 and a base material 107 to form a meniscus 103Ma, and the base material is conveyed in an arrow direction to form a primary coating film 108a.

In the embodiment, a cross-sectional shape of the coating bar 101 is arbitrary. The cross-sectional shape is, for example, a circular shape, a flat circular shape, or a polygonal shape. A portion of the cross-sectional shape that corresponds to a meniscus forming portion may be curved, and the other portion may be linear. For example, a cross-sectional shape of a surface of the coating bar 101 that faces the base material 107 may be curved.

The coating bar can be arranged so as not to rotate. As the coating bar does not rotate like a roller, stability of the meniscus is improved.

The coating bar 101 contains, for example, at least one selected from the group consisting of stainless steel, aluminum, titanium, and glass. Therefore, processing is facilitated when preparing the coating bar 101. In one example, the surface of the coating bar 101 is a mirror surface. In another example, the surface of the coating bar 101 may have an uneven structure.

Then, as illustrated in Figs. 1 and 2, the leveling bar 105 is installed at a position downstream of the coating bar 101 in a coating direction.

The coating bar 101 applies the coating liquid 103 to almost the entire surface of the base material 107 to form the coating film 108a, but uniformity of the coating film 108a may be insufficient. The coating film 108a formed in the present embodiment comes into contact with the leveling bar 105 arranged at a position downstream of the coating bar as the base material is conveyed. As illustrated in Fig. 1, the meniscus 103Mb of the coating liquid 103 can be formed between the base material 107 and the leveling bar 105. As the coating liquid 103 spreads in a lateral direction of a gap between the leveling bar 105 and the base material 107, the uniform meniscus 103Mb is formed by a surface tension of the coating liquid. When the meniscus 103Mb comes into contact with the base material 107, a secondary coating film 108b having high uniformity and formed by the coating 103 is formed on the base material 107. An intended film (solid film) is obtained by solidifying the coating film 108b by, for example, drying. For example, a drying member 109 can be arranged at a position downstream of the leveling bar.

As described above, the coating film 108b having a large area can be formed on the base material 107, for example, by moving the base material 107 in a movement direction (an arrow direction in the drawing).

The coating device illustrated in Figs. 1 and 2 forms the primary coating film by the meniscus method, and the coating device may further include a nozzle position adjustment member 110 that adjusts a position of the nozzle 106, a nozzle position detection member 111 that detects a distance between the coating bar 101 and the nozzle 106, and the like in order to improve the uniformity of the primary coating film.

In a case where the nozzle is used to form the primary coating film, a plurality of nozzles 106 or a plurality of pumps 104 can be used as illustrated in Fig. 2. The plurality of nozzles 106 can face the coating bar 101. As illustrated in Fig. 2, the plurality of nozzles 106 can supply the coating liquid 103 toward the coating bar 101. Note that an additional nozzle for supplying the coating liquid to the leveling bar 105 may be further provided. It is possible to form a meniscus between the base material and the leveling bar before forming the primary coating film before the coating is started by arranging such an additional nozzle.

As illustrated in Fig. 2, the plurality of nozzles 106 are arranged in a first direction. The first direction is, for example, a Y-axis direction. One direction perpendicular to the Y-axis direction is defined as an X-axis direction. The movement direction of the base material can coincide with an X axis. A direction perpendicular to the Y-axis direction and the X-axis direction is defined as a Z-axis direction. The coating bar 101 extends, for example, in the Y-axis direction.

In the embodiment, the number of plurality of nozzles 106 may be three or more. As a result, the primary coating film 108a having a large area can be stably formed. In the example of Fig. 2, the number of plurality of nozzles 106 is four. In the embodiment, the number may be an arbitrary integer of 3 or more.

In the embodiment, the nozzle can be a slot die or can have a needle shape. For example, a discharge amount of the coating liquid 103 can be controlled with high accuracy by using the plurality of needle-shaped nozzles 106. When the nozzle has the needle shape, for example, tips of the plurality of nozzles are easily brought into contact with the coating bar 101. The needle-shaped nozzle has high flexibility. Due to the high flexibility, for example, damage to the nozzle due to vibration of the coating bar 101 or the like can be suppressed. In the needle-shaped nozzle, a length of the nozzle is, for example, 10 mm or more and 100 mm or less, and an inner diameter of the nozzle is, for example, 0.5 mm or more and 2 mm or less. An angle between an end surface of the tip of the nozzle and an extending direction of the nozzle is, for example, about 90 degrees (for example, 75 degrees or more and 105 degrees or less). With such a shape, for example, occurrence of scratches on the coating bar 101 can be suppressed.

However, in a case where there are a plurality of nozzles, a distance between the coating bar 101 and the tip of each nozzle tends to vary. When there is variation, the meniscus 103Ma formed from each nozzle is likely to be disturbed, and as a result, the coating film 108a is likely to be non-uniform.

If the nozzle position adjustment member 110 that adjusts the position of each nozzle and the nozzle position detection member 111 that detects a distance between the coating bar 101 and each nozzle 106 are provided as illustrated in Figs. 1 and 2, it is possible to reduce variation in the position and the distance between the tip of each nozzle and the coating bar, and to achieve uniform coating.

In the embodiment, a member that detects contact between the coating bar and each nozzle can be further provided. The contact is easily detected by, for example, a method of measuring an electric resistance between the nozzle and the coating bar, and thus, the variation can be reduced by adjusting a coating condition based on the contact. When the nozzle is in contact with the coating bar, the coating liquid can be directly applied to the coating bar, and repelling of the coating liquid hardly occurs.

In the embodiment, a member that measures the electric resistance between each nozzle and the coating bar can be provided as the member that detects the contact between the coating bar and each nozzle. If each nozzle and the coating bar are made of conductive stainless steel or the like, and the nozzles are insulated from each other, when the electric resistance between the coating bar and each nozzle is measured, the electric resistance is drastically reduced at a moment of contact. In addition, since the electric resistance changes as a contact state changes, the contact state can be monitored. For example, in a state in which the nozzle is pressed against the coating bar so strongly as to be greatly curved, the coating bar comes into contact with not only the tip of the nozzle but also a side surface of the nozzle, and the electric resistance becomes very low. In this case, the coating liquid is easily ejected from the tip of the nozzle to a portion other than the coating bar, and uneven coating is likely to occur. Since an optimum electric resistance varies depending on a shape and material of the nozzle and the coating bar, it is desirable to measure the optimum electric resistance in advance.

It is desirable to install a wiring connected to an electric resistance measuring instrument between the nozzles and the coating bar in advance. A switching portion is provided in the wiring, and each nozzle can be moved to confirm the contact with the coating bar before coating. If the electric resistance is also measured during the coating, it is possible to detect a case where there is an abnormality in the contact between the nozzle and the coating bar. The electric resistance measuring instrument can also be an external device separate from the coating device.

Note that, in the coating device according to the embodiment, the nozzle is preferably detachable. The nozzle is likely to be clogged due to a small opening. In the coating device according to the embodiment, when such clogging occurs, an ejection amount from each nozzle can be adjusted by the coating liquid supply member and a coating liquid supply amount adjustment member, but when clogging becomes severe or the ejection becomes completely impossible, it is necessary to perform cleaning or replacement. In such a case, it is preferable that the nozzle is detachable to facilitate maintenance.

In the above description, a case where the primary coating film 108a is formed by the meniscus method by supplying the coating liquid from the plurality of nozzles illustrated in Figs. 1 and 2 has been described, but the primary coating film may be formed by another method. For example, a slit die head that uses the coating bar for slit coating, includes a manifold therein, and supplies the coating liquid from the manifold to the surface of the base material via a slit can be used instead of the plurality of nozzles. Further, the coating liquid can be supplied to the coating bar by using the slit die head instead of the nozzle in Figs. 1 and 2.

The coating device 100 may further include the drying member 109. The drying member 109 can dry the coating film 108b applied to the base material 107. The drying member 109 may include, for example, an air nozzle or a far-infrared lamp.

A distance between the coating bar 101 and the leveling bar 105 can be freely changed.

In addition, it is preferable to provide a member that controls an interval between the leveling bar 105 and the base material 107. For this purpose, a gap ring, a micrometer, or the like can be used.

The leveling bar may be linear or curved. When the leveling bar is linear, uniformity of a thickness of the coating film is easily achieved. When the leveling bar is curved, for example, the thickness is easily changed such that the center is thicker, but the uniformity in the coating direction is easily achieved.

In the embodiment, a cross-sectional shape of the leveling bar 105 is arbitrary. The cross-sectional shape is, for example, a circular shape, a flat circular shape, or a polygonal shape. A portion of the cross-sectional shape may be curved, and the other portion may be linear. For example, a cross-sectional shape of a surface of the leveling bar 105 that faces the base material 107 may be curved.

The leveling bar can be arranged so as not to rotate. As the leveling bar does not rotate like a roller, stability of the meniscus is improved.

The leveling bar 105 contains, for example, at least one selected from the group consisting of stainless steel, aluminum, titanium, and glass. Therefore, processing is facilitated when preparing the leveling bar 105. In one example, the surface of the leveling bar 105 is a mirror surface. In another example, the surface of the leveling bar 26 may have an uneven structure.

### (Second Embodiment)

A second embodiment relates to a coating method. In the coating method according to the embodiment, for example, coating is performed using the coating device 10 (and a modification thereof) described in the first embodiment.

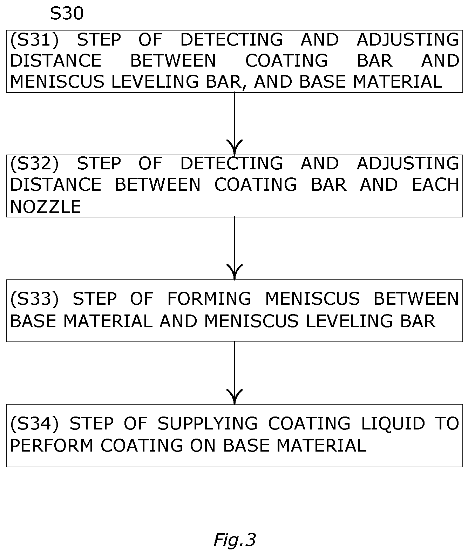

Fig. 3 is a flowchart illustrating the coating method (S30) according to the second embodiment. The coating method for forming and applying a meniscus of a coating liquid includes: a step (S31) of detecting and adjusting a distance between a coating bar and a meniscus leveling bar, and a base material; a step (S32) of detecting and adjusting a distance between the coating bar and each nozzle; a step (S33) of forming a meniscus between the base material and the leveling bar; and a step (S34) of supplying the coating liquid to perform coating on the base material. Here, a meniscus M22 is stably formed in a coating process by performing the step of S33 before the step of S34. It is preferable to arrange an additional nozzle that supplies the coating liquid to the leveling bar in order to form a meniscus between the base material and the leveling bar before the start of coating as described above.

In the embodiment, the distance between the coating bar and each nozzle can be detected by measuring an electric resistance between the coating bar and the nozzle. In addition, each nozzle can be installed on one cantilever fixing plate capable of rotation, horizontal movement, or vertical movement. With such an arrangement, it is possible to simultaneously adjust positions of all the nozzles.

Hereinafter, specific examples of the coating device and the coating method according to the embodiment will be described.

For example, a solar cell can be formed by coating with the coating device 100. In one example, the number of pumps is four. A pipe connected to one pump is connected to four nozzles. The total number of nozzles is 16. The nozzle is installed on one cantilever bar. An actuator for movement and a wiring for measuring the electric resistance are installed in each nozzle. The wiring is connected to the electric resistance measuring instrument. The nozzle position detection member such as a camera for observing a positional relationship between the nozzle and the coating bar is installed.

For example, the base material 107 is a roll-shaped PET film. A width of the PET film is, for example, 330 mm. A light-transmissive electrode having a width of 300 mm is formed on the PET film by a roll-to-roll sputtering device. A sheet resistance of the electrode is, for example, 10 Ω/□. The electrode has, for example, a laminated structure of ITO film/Ag alloy/ITO film. For example, a plurality of electrodes are provided. A length of one of the plurality of electrodes is, for example, about 10 mm. An interval between the plurality of electrodes is, for example, 50 µm.

Cross sections of the coating bar 101 and the leveling bar 105 are circular. A radius of the circle is 10 mm. A length of the coating bar 101 and the leveling bar 105 is 300 mm. The coating bar 101 and the leveling bar 105 contain, for example, stainless steel (for example, SUS303).

The nozzle includes a stainless steel locking base. The length of the nozzle is 50 mm. A pipe for the coating liquid is a polytetrafluoroethylene tube. The nozzle and the pipe are connected by a detachable joint. The pipe is connected to the pump.

In one example, a hole transport layer is formed by the coating liquid 103. In this case, the coating liquid 103 is an aqueous solution containing PEDOT and PSS.

For example, the gap ring or the actuator controls a relative positional relationship between the coating bar 101 and the leveling bar 105, and the base material 107.

For example, the nozzle is brought into a horizontal state. In such a state, the coating liquid 103 is supplied, and air in the nozzle is discharged.

Thereafter, the tip of the needle nozzle is lowered and inclined by 20° from the horizontal state. The cantilever is brought close to the coating bar. Next, each nozzle is brought close to and into contact with the coating bar one by one such that the electric resistance becomes 10 to 50 Ω.

The coating liquid is supplied to the leveling bar 105 with a syringe to form the meniscus 103Mb between the leveling bar 105 and the base material 107.

The coating liquid 103 is continuously supplied by the pump while the base material 107 is conveyed. A movement speed of the base material 107 is, for example, 5 m/min. The drying member 109 blows heated dry air to the applied coating liquid 103. A solidified coating film is obtained from the coating liquid 103.

In the embodiment, another coating liquid may be further applied after the above coating. The another coating liquid contains, for example, a semiconductor material. The another coating liquid contains, for example, PTB7 ([poly{4,8-bis[(2-ethylhexyl)oxy]benzo[1,2-b:4,5-b']dithiophene-2,6-diyl-1t-alt-3-fluoro-2-[(2-ethylhexyl)carbonyl]thieno[3,4-b]thiophene-4,6-diyl}]) and PC70BM ([6,6]-phenyl-C71-butyric acid methylester). PTB7 is, for example, a p-type semiconductor. PC70BM is, for example, an n-type semiconductor. The another coating liquid further contains, for example, monochlorobenzene. An amount of PTB7 is 8 mg for 1 mL of monochlorobenzene. An amount of PC70BM is 12 mg for 1 mL of monochlorobenzene. The another coating liquid is a dispersion liquid containing an organic semiconductor.

The another coating liquid is, for example, a semiconductor film of a solar cell. When applying the another coating liquid, a minimum distance between the coating bar 101 and the base material 107 is 300 µm. The movement speed of the base material 107 is, for example, 5 m/min. After the coating, drying is performed by the drying member 109.

For example, there are an organic thin-film solar cell using an organic semiconductor and an organic/inorganic hybrid solar cell. By preparing such solar cells by the coating method, a high-performance solar cell can be prepared.

In the embodiment, the coating liquid 103 may be applied to the base material 107 at a position where the base material 107 is conveyed in a vertical direction. As a result, for example, an effect of gravity is applied to the meniscus, and a uniform film is easily obtained even at high speed.

According to the embodiments, the coating device and the coating method capable of forming a uniform coating film are provided.

The embodiments of the present invention have been described above with reference to specific examples. However, the present invention is not limited to the specific examples. For example, a specific configuration of each element such as the pipe, the pump, the nozzle, and a holding unit included in the coating device is included in the scope of the present invention as long as those skilled in the art can similarly carry out the present invention and obtain the same effect by appropriately selecting the configuration from known ranges.

In addition, a combination of any two or more elements of the respective specific examples within a technically possible range is also included in the scope of the present invention as long as the combination includes the gist of the present invention.

In addition, all the coating devices and coating methods that can be implemented by those skilled in the art by appropriately changing the design based on a coating head, the coating device, and the coating method described above as the embodiments of the present invention are also within the scope of the present invention as long as the coating devices and coating methods include the gist of the present invention.

In addition, those skilled in the art can conceive various changes and modifications within the scope of the idea of the present invention, and it is understood that the changes and modifications also fall within the scope of the present invention.

Although some embodiments of the present invention have been described, the embodiments have been presented as examples and are not intended to limit the scope of the invention. These novel embodiments can be implemented in various other forms, and various omissions, substitutions, and changes can be made without departing from the gist of the invention. The embodiments and modifications thereof are included in the scope and gist of the invention, and are included in the invention described in the claims and the equivalent scope thereof.

### REFERENCE SIGNS LIST

- 100: COATING DEVICE
- 101: COATING BAR
- 102: BASE MATERIAL CONVEYANCE MEMBER
- 103: COATING LIQUID
- 104: COATING LIQUID SUPPLY MEMBER
- 105: LEVELING BAR
- 106: NOZZLE
- 107: BASE MATERIAL
- 108a: PRIMARY COATING FILM
- 108b: SECONDARY COATING FILM
- 109: DRYING MEMBER
- 110: NOZZLE POSITION ADJUSTMENT MEMBER
- 111: NOZZLE POSITION DETECTION MEMBER
- 112: LIQUID RESERVOIR

## Claims

1. A coating device comprising: a coating bar; a base material conveyance member that conveys a base material; and a coating liquid supply member that supplies a coating liquid to said coating bar, wherein said coating device further comprises a leveling bar provided at a position downstream of said coating bar in a coating direction, and said leveling bar is arranged at a position where said coating liquid forms a meniscus between said leveling bar and said base material.

2. The coating device according to claim 1, further comprising a leveling bar position adjustment member that controls an interval between said leveling bar and said base material.

3. The coating device according to claim 1 or 2, wherein said leveling bar is arranged so as not to rotate.

4. The coating device according to claim 1 or 2, further comprising a coating bar position adjustment member that controls a position of said coating bar.

5. The coating device according to claim 1 or 2, wherein said coating liquid is supplied from a plurality of nozzles.

6. The coating device according to claim 5, wherein opening surfaces of the plurality of nozzles have a needle shape cut to an angle of 75 degrees or more and 105 degrees or less.

7. The coating device according to claim 5, wherein said nozzle is detachable.

8. The coating device according to claim 5, further comprising a nozzle that supplies said coating liquid to said leveling bar.

9. The coating device according to claim 1 or 2, wherein said coating liquid is supplied from a slit die head.

10. The coating device according to claim 1 or 2, wherein said leveling bar is curved.

11. A coating method for preparing a coating film by applying a coating liquid to a surface of a base material using a coating bar, said coating method comprising: arranging a leveling bar at a position downstream of said coating bar in a coating direction; and forming a meniscus between said base material and said leveling bar by said coating liquid supplied from a primary coating film formed by said coating bar to form a secondary coating film.

12. The coating method according to claim 11, wherein said coating liquid is supplied from a plurality of nozzles to a surface of said coating bar, and said coating liquid is supplied from said surface to between said coating bar and said base material to form said primary coating film.

13. The coating method according to claim 12, wherein said coating liquid is supplied after adjusting positions of the plurality of nozzles and detecting a distance between said coating bar and said plurality of nozzles.

14. The coating method according to claim 13, wherein said distance is detected by measuring an electric resistance between said nozzle and said coating bar.

15. The coating method according to claim 12, wherein the plurality of nozzles are installed on one cantilever fixing plate capable of rotation, horizontal movement, or vertical movement.

## Amended claims

### Amended claims under Art. 19.1 PCT

1. A coating device comprising: a coating bar; a base material conveyance member that conveys a base material; and a coating liquid supply member that supplies a coating liquid to said coating bar, wherein said coating device further comprises a leveling bar provided at a position downstream of said coating bar in a coating direction, and said leveling bar is arranged at a position where said coating liquid forms a meniscus between said leveling bar and said base material, still further comprising a leveling bar position adjustment member that controls an interval between said leveling bar and said base material.

2. (Canceled)

3. The coating device according to claim 1, wherein said leveling bar is arranged so as not to rotate.

4. The coating device according to claim 1 or 2, further comprising a coating bar position adjustment member that controls a position of said coating bar.

5. The coating device according to claim 1 or 2, wherein said coating liquid is supplied from a plurality of nozzles.

6. The coating device according to claim 5, wherein opening surfaces of the plurality of nozzles have a needle shape cut to an angle of 75 degrees or more and 105 degrees or less.

7. The coating device according to claim 5, wherein said nozzle is detachable.

8. The coating device according to claim 5, further comprising a nozzle that supplies said coating liquid to said leveling bar.

9. The coating device according to claim 1 or 2, wherein said coating liquid is supplied from a slit die head.

10. The coating device according to claim 1 or 2, wherein said leveling bar is curved.

11. A coating method for preparing a coating film by applying a coating liquid to a surface of a base material using a coating bar, said coating method comprising: arranging a leveling bar at a position downstream of said coating bar in a coating direction; and forming a meniscus between said base material and said leveling bar and controlling an interval between said leveling bar and said base material by said coating liquid supplied from a primary coating film formed by said coating bar to form a secondary coating film.

12. The coating method according to claim 11, wherein said coating liquid is supplied from a plurality of nozzles to a surface of said coating bar, and said coating liquid is supplied from said surface to between said coating bar and said base material to form said primary coating film.

13. The coating method according to claim 12, wherein said coating liquid is supplied after adjusting positions of the plurality of nozzles and detecting a distance between said coating bar and said plurality of nozzles.

14. The coating method according to claim 13, wherein said distance is detected by measuring an electric resistance between said nozzle and said coating bar.

15. The coating method according to claim 12, wherein the plurality of nozzles are installed on one cantilever fixing plate capable of rotation, horizontal movement, or vertical movement.
